# EUROPEAN PATENT APPLICATION

(11) **EP 2 381 482 A1**
(43) Date of publication of application: **26.10.2011**
(21) Application number: 10290216.0
(22) Date of filing: 22.04.2010
(51) Int. Cl.: H01L 31/0216, H01L 31/0224, H01L 31/18, H01L 31/06, B23K 26/00

(54) **Improved method for manufacturing a photovoltaic cell comprising a TCO layer**

(71) Applicant: Excico Group NV, 3500 Hasselt (BE)
(72) Inventor: The designation of the inventor has not yet been filed
(74) Representative: BiiP cvba

(57) **Abstract**

The present invention is directed to a method for fabricating a photovoltaic device, comprising depositing a TCO-layer on a substrate and annealing the TCO layer by laser irradiation having irradiation parameters, characterized in that the irradiation parameters are selected such that the annealing comprises increasing the haze% of the TCO layer compared to the as deposited TCO layer.

Additionally, the present invention is directed to a TCO layer having a haze% of at least 2% in the visible light wavelength range and a surface roughness of less than 10 nanometer RMS.

Further the present invention is directed to a photovoltaic device comprising such TCO-layer.

## Description

### FIELD OF THE INVENTION

The present invention relates to a method for fabricating a photovoltaic device, comprising depositing a transparent conductive oxide (TCO) layer on a substrate, and annealing the TCO layer by laser irradiation. Further, the invention relates to an improved TCO layer and a photovoltaic cell comprising such TCO layer.

### BACKGROUND OF THE INVENTION

As commonly known, the more incident light is trapped, the better the quantum efficiency (QE) and short circuit current density (Jsc) of a photovoltaic cell. Therefore, techniques for improving light trapping are used to enhance absorption of incident light and short-circuit current in photovoltaic cells.

One of these techniques is inducing haze or light scattering at the interfaces of the photovoltaic device. Therefore typically a substrate with a textured surface is utilized to generate roughness at the interfaces. When light photons hit the rough surface of an absorbing film at a given incident angle, higher angles of refraction are generated inside the absorbing film than the angle of refraction that can be classically calculated on a planar interface with the incident angle and material index of refraction. Hence, light photons will travel over a longer distance into the absorbing film, increasing the amount of absorbed light. Also on rough surfaces, much fewer photons are reflected off the surface hence more photons are absorbed inside the film, increasing light scattering and trapping in the photovoltaic device.

Transparent conductive oxide (TCO) layers, either deposited in "superstrate" configuration on top of an absorbing layer, either deposited in "substrate" configuration on a glass or polymer substrate or on top of a metal layer or a metallic substrate as part of an internal reflector assembly, are used because of their high conductivity, low optical absorption and high scattering properties.

As described in Chimdindu U. Nebo's Thesis, TUDelft, September 2009, TCO layers for photovoltaic cells can be provided with native or post-fabricated surface roughness in order to induce haze and to scatter incident light more efficiently.

A first problem when increasing the TCO surface roughness is that, since post-fabricated surface roughness is usually obtained by texturizing by means of wet chemical etching as described in DE19713215, this roughening step can generate some limitations. On the one hand and for a given TCO thickness, etching will result in material losses that will in turn result in a loss of electrical conductivity. On the other hand for a given TCO roughness and electrical conductivity, a thicker TCO film may be grown but such thicker layer will absorb more light (lost for the PV device) and will require longer deposition times.

A second more general problem rising when increasing the TCO surface roughness is decreased TCO surface quality. In particular in substrate configuration, where a thin silicon absorber layer is deposited on the TCO, insufficient TCO surface quality results in insufficient silicon layer quality. Thereby pinholes or shorts are generated at the silicon-TCO interface due to sharp peaks and valleys topography, resulting in decreased photovoltaic cell performance.

In an attempt to overcome the above problem, alternative absorber material that can be deposited in larger thicknesses (1µm and more) such as for example cadmium telluride, may be used.

Another solution proposed by Dong-Won Kang et al. (Highly Transparent and High Haze ZnO:Al film For Front TCO of a-Si:H and µc-Si:H Solar Cells by Controlling Oxygen Flow) may be to modify the TCO morphology by 2 steps TCO deposition on seed layer and subsequent texturizing step. It is clear this results in rather complex and expensive processing.

Considering the above, it is a first object of the present invention to provide a TCO layer with increased scattering or light trapping properties while keeping sufficient surface layer quality, a photovoltaic cell comprising such TCO layer, and a method for manufacturing such photovoltaic cell.

It is a second object of the present invention to provide a method for manufacturing a photovoltaic cell enabling treatment of a TCO at specific location(s) and over pre-defined area(s) to improve its scattering properties.

It is third object of the present invention to provide a more simple and more cost-effective method for providing a TCO layer with increased light trapping and surface quality properties from TCO deposited at low or even room temperature.

It is a fourth object of the present invention to provide simultaneously a method for providing a TCO layer with lower optical absorption in the blue part of the solar spectrum and enhanced electrical conductivity performances from TCO deposited at low or even room temperature.

Further, it is an object of the present invention to provide a TCO having sufficient surface quality to decrease electrical shorts occurrence in thin film photovoltaic cells, particularly thin film photovoltaic cells with absorbing layer thickness less than 2µm like those used in single, and multi-junction amorphous silicon solar cells and in tandem micromorph silicon solar cells.

Another object of the present invention is to provide a photovoltaic cell with improved performance and efficiency.

The present invention meets the above objects by laser annealing the TCO layer using irradiation parameters which are selected such that the annealing comprises increasing the haze% of the TCO layer compared to the as deposited TCO layer.

### SUMMARY OF THE INVENTION

The present invention is directed to a method for fabricating a photovoltaic device, comprising depositing a TCO-layer on a substrate and annealing the TCO layer by laser irradiation having irradiation parameters,
characterized in that the irradiation parameters are selected such that the annealing comprises increasing the haze% of the TCO layer compared to the as deposited TCO layer.

Additionally, the present invention is directed to a TCO layer having a haze% of at least 2% in the visible light wavelength range and a surface roughness of less than 10 nanometer RMS.

Further the present invention is directed to a photovoltaic device comprising such TCO-layer.

### DESCRIPTION OF THE INVENTION

According to a first embodiment of the present invention, a method for fabricating a photovoltaic device is provided, comprising depositing a TCO-layer on a substrate, and annealing the TCO layer by laser irradiation having irradiation parameters,
characterized in that the irradiation parameters are selected such that the annealing comprises increasing the haze% of the TCO layer compared to the as deposited TCO layer.

As known by a person skilled in the art, in the field of flexible displays laser annealing is used for annealing TCO layers subsequent to low thermal budget deposition. In that case the annealing step aims to increase the optical transmission in the visible range and to decrease the haze%, as illustrated in Laser-Crystallized High Quality ITO on Plastic Substrates for Flexible Displays (Wonsuk Chung et al). Surprisingly, it has now been found that laser annealing upon selecting the appropriate irradiation parameters can also be used to induce haze to the TCO layer.

In the context of the present invention, haze percentage (haze%) is the percentage of incident light scattering out of specular direction. In particular haze% for transmitted light is of utmost importance since this parameter influences the length of the light path in the absorber layer of the photovoltaic cell, which on its turn contributes to a higher probability in generating photo-carriers in the absorber layer.

In general, haze% is dependent on refractive indices, roughness of the surface, incident angle of the light photons and wavelength. Without being bound by any theory it is believed that by laser annealing with the appropriate irradiation parameters, the grain morphology and distribution as well as the grain boundaries properties in the bulk TCO layer are modified rather than inducing more roughness to the TCO surface layer, such that the haze% of the TCO layer is increased compared to the as deposited TCO layer, resulting in improved scattering or light trapping properties, while keeping sufficient surface layer quality Consequently, haze % increase may result in higher photovoltaic cell performance and efficiency.

The haze% of the TCO layer may be increased compared to the as deposited TCO layer with at least 2%, at least 5%, at least 10%, at least 15%, or at least 20% in the visible light wavelength range.

A further advantage is that laser annealing enables treatment of a TCO at specific location(s) and over pre-defined area(s), such that only on those locations or areas scattering properties may be improved, while on other locations or areas the TCO may be kept as deposited.

Another advantage is that the present invention enables manufacturing a TCO layer with increased light trapping and surface quality properties from TCO deposited at low or even at room temperature, such that underlying layers or an underlying fragile substrate will not be exposed to exceeding thermal budget which may degrade those underlying layers or fragile substrate.

Still another advantage is that the present invention enables manufacturing a TCO layer with lower optical absorption in the blue part of the solar spectrum and enhanced electrical conductivity performances from TCO deposited at low or even room temperature. The percentage transmission in the blue part of the solar spectrum (400-500nm) may be at least 5, at least 10, or at least 15% from as deposited TCO.

In embodiment in accordance with the present invention, the irradiation parameters may be selected such that the annealing additionally comprises decreasing the Root Mean Square (RMS) surface roughness of the TCO layer compared to the as deposited TCO layer. The surface roughness after annealing may be less than 10, less than 7.5, less than 5, or less than 2.5 nanometer RMS as measured by high resolution Atomic Force Microscopy (AFM).

Without being bound by any theory it is believed that by laser annealing with the appropriate irradiation parameters, the grain morphology and distribution as well as the grain boundaries properties in the bulk TCO layer may be modified while lowering the RMS surface roughness of the TCO surface layer. Decreased RMS surface roughness of the TCO layer compared to the as deposited TCO layer helps avoiding pinholes and shorts generated at the TCO-absorber interface. Lower electrical shorts occurrence at TCO surface will result in higher photovoltaic cell performance and efficiency.

In another embodiment in accordance with the present invention, the irradiation parameters may be selected such that the annealing additionally comprises generating a grain size of the TCO layer greater than the grain size of as deposited TCO, or generating a grain size of at least 70, at least 80, at least 90, or at least 100 nanometer.

In accordance with the present invention, the laser irradiation may be pulsed and may be in the range of 100 ns to 1000 ns, or between 100 ns and 600 ns, between 100 ns and 300 ns, or preferably between 100 and 200 nanoseconds.

Further in accordance with the present invention, the laser irradiation may expose the TCO layer to a temperature of at least the melting temperature of the TCO.

In an embodiment in accordance with the present invention, the irradiation may be pulsed wherein with each pulse a portion of at least 1 cm², at least 5 cm², at least 10 cm², at least 20 cm², or at least 40cm² (25*0.7) may be irradiated, which makes the present invention suitable for industrial manufacturing of thin film photovoltaic cells on large substrates at high throughputs.

Alternatively, the laser irradiation may comprise scanning the TCO-layer with a line beam having a line length equal to or (slightly) exceeding one dimension of the TCO surface layer, which makes the present invention suitable for industrial manufacturing of in particular thin film photovoltaic cells at high throughputs. For example, by having a large TCO coated substrate continuously flowing in a direction perpendicular to the line beam at a scanning speed (several mm/sec), consecutive pulsed laser shots will enable continuous anneal of the whole TCO area of a large quantity of TCO coated substrates.

The laser may be any laser whose wavelength, energy and pulse duration is adapted to the process, such as solid state lasers, or excimer laser. Preferably, the laser may be an excimer laser, more preferably a xenon chloride excimer laser.

The wavelength of the laser may be in the range 190 nm to 600 nm, 190 nm to 550 nm, 190 nm to 480 nm due to the high energy absorption of TCO at those wavelengths, and preferably 308 nm.

The laser energy may be in the range of 1 Joules to 25 Joules. In order to achieve these energies, the laser discharge volume is optimized to typically 10 cm (inter electrodes spacing) x 7 to 10 cm (discharge width) x 100 to 200 cm (discharge length).

In an embodiment of the present invention, the laser may be adapted to produce a projected laser beam with an energy density between 0.1 and 10 J/cm², preferably between 0.1 and SJ/cm², and even more preferably between 0.1 and 2 J/cm².

In a preferred embodiment, the laser may be an excimer laser adapted to produce a large area output beam of more than 60 cm², more than 80 cm², preferably 100 cm², having a projected beam spot typically of at least 1 cm² , at least 5 cm², and up to 20 or even 40 cm² with an energy density between 0.1 and 10 J/cm².

In a preferred embodiment of the present invention, the laser may have a wavelength of 308 nm, a pulse duration between 100 and 200 nanoseconds and a projected beam energy density between 0.1 and 10 J/cm².

The TCO material may be any TCO material used in photovoltaics, such as for example fluorine doped tin oxide (SnO2:F), intrinsic zinc oxide (i-ZnO), aluminum doped ZnO (Al:ZnO or AZO), tin doped indium oxide (ITO), titanium doped indium oxide (ITiO), zinc doped indium oxide (IZO), zinc magnesium oxide (ZnMgO), gallium indium oxide (GalnO3 cadmium oxide (Cd:O), cadmium (indium) zinc oxide (Cd₁₊ₓln₂₋₂ₓSnₓO4 (from Cdln2O4 to Cd2SnO4)), or titanium oxide (TiO2) including niobium-doped or tantalum-doped TiO2.

These TCO materials may be used in either amorphous or in microcrystalline film structure, depending on deposition technique and process conditions. Preferably low temperature deposition is used. These materials may also be dispensed as bound TCO particles in a paste or a solution by various deposition technologies, such as for example inkjet printing or screen printing or spraying.

The substrate may be any kind of substrate used in photovoltaics. Examples are glass, polymer (rigid or flexible) such as polyethylene terephtalate (PET) or polyethylene naphtalate (PEN), or any semiconductor material (bulk or thin film) suitable for photovoltaic applications such as for example mono crystalline silicon, undoped silicon or doped silicon, polycrystalline silicon, implanted silicon, silicon carbide, amorphous silicon, silicon germanium, III-V compound semiconductors such as gallium arsenide, gallium aluminum arsenide, gallium nitride, II-VI compound semiconductors like cadmium telluride, copper indium diselenide (CuInSe2) or copper indium gallium diselenide (Cu(In,Ga)Se2) and the like, or multi-junction semiconductor stacks and the like.

A method according to the invention may further comprise aligning the projected laser beam in XYZ-direction with the portion to be irradiated.

A method in accordance with the present invention may further comprise shaping the laser beam to a 2D-pattern by any kind of beam shaping system, wherein the 2D-pattern corresponds to the area of TCO to be modified. Shaping the laser beam to a 2D-pattern obviously favours treatment of a TCO at specific location(s) and over pre-defined area(s). The size of the image of the 2D-pattern may be matched to the size of the area of TCO to be modified. This may be obtained by means of a variable image magnification system.

Further adjustment may be performed by visualizing the beam spot on the semiconductor material layer using a camera, measuring its size and adjusting the magnification.

A method of the present invention may comprise also pattern recognition. This may be achieved by a pattern recognition system comprising a camera, mechanically linked to a stage for holding the substrate, and positioned above the TCO surface. In a specific embodiment, the image from the camera may be processed to locate several (typically 3) alignment marks that have been etched or laser ablated on the substrate. The alignment marks provide the precise location of the TCO area to be modified in the coordinate system of the laser equipment.

In an additional embodiment in accordance with the present invention, a TCO layer may be provided having a haze% of at least 2%, at least 5%, at least 10%, at least 15%, or at least 20% in the visible light wavelength range and a surface roughness of less than 10, less than 7.5, less than 5, or less than 2.5 nanometer RMS as measured by high resolution Atomic Force Microscopy (AFM).

Such TCO layer may show improved scattering or light trapping properties, while having limited surface roughness in order to reduce the amount of pinholes and shorts generated at the TCO-absorber interface. This will result in higher photovoltaic cell performance and efficiency.

In accordance with the present invention, the TCO layer may have a grain size of at least 70, at least 80, at least 90, or at least 100 nanometer.

As an example, a TCO layer in accordance with the present invention may be used in a substrate configuration in a thin film photovoltaic device based on polymorph silicon tandem technology, or in a superstrate configuration on top of a copper indium diselenide (CIS) or copper indium gallium diselenide (CIGS) or copper indium sulfide (CulnS2) or copper-indium-gallium-sulphur-selenium (CIGSSe) absorbing layer, or in a substrate configuration on top a metal layer or metal substrate as part of a light reflector assembly.

Further, in a final embodiment in accordance with the present invention, a photovoltaic device is provided comprising a TCO-layer as described in the above embodiments. Such photovoltaic cells may be for example standard mono-crystalline and multi-crystalline solar cells, N-type and P-type solar cells, epitaxial silicon solar cells grown on different types of substrates, hetero-junction solar cells, back contact or rear contact solar cells (RCC, BCC) and interdigitated back contact cells (IBC), organic photovoltaic solar cell or dye-sensitized solar cells (DSSC, DSC or DYSC).

## Claims

1. A method for fabricating a photovoltaic device, comprising depositing a TCO-layer on a substrate, and annealing the TCO layer by laser irradiation having irradiation parameters,
**characterized in that** the irradiation parameters are selected such that the annealing comprises increasing the haze% of the TCO layer compared to the as deposited TCO layer.

2. A method according to claim 1, wherein the irradiation parameters are selected such that the annealing additionally comprises decreasing the RMS surface roughness of the TCO layer compared to the as deposited TCO layer.

3. A method according to claims 1 or 2, wherein the irradiation parameters are selected such that the annealing additionally comprises generating a grain size of the TCO layer of at least 70 nanometer.

4. A method according to claims 1 to 3, wherein the laser irradiation is pulsed and has a pulse duration from 100 to 1000 nanoseconds.

5. A method according to claims 1 to 4, wherein the laser irradiation exposes the TCO layer to a temperature of at least the melting temperature of the TCO.

6. A method according to claims 1 to 5, wherein the laser irradiation has a beam energy density between 0.1 and 10 Joule/cm².

7. A method according to claims 1 to 6, wherein the laser irradiation comprises scanning the TCO-layer with a line beam having a line length equal to or exceeding one dimension of the TCO surface layer.

8. A method according to claims 1 to 6, wherein the irradiation is pulsed and wherein with each pulse an area of at least 1 cm² is irradiated.

9. A method according to claims 1 to 8, wherein annealing is performed by an excimer laser.

10. A method according to claims 1 to 9, wherein depositing the TCO layer comprises low-temperature deposition, inkjet printing or screen printing, or solution spraying.

11. A TCO layer having a haze% of at least 2% in the visible light wavelength range and a surface roughness of less than 10 nanometer RMS.

12. A TCO layer according to claims 11 having a grain size of at least 70 nanometer.

13. A photovoltaic device comprising a TCO-layer according to claims 11 to 12.
